# EUROPEAN PATENT APPLICATION

(11) **EP 2 587 547 A1**
(43) Date of publication of application: **01.05.2013**
(21) Application number: 12189647.6
(22) Date of filing: 23.10.2012
(51) Int. Cl.: H01L 31/0224, H01L 31/18, H05K 3/12

(54) **METHODS FOR THE CLOSED-LOOP FEEDBACK CONTROL OF THE PRINTING OF A MULTILAYER PATTERN OF A SOLAR CELL**

(30) Priority: 24.10.2011 IT UD20110171; 27.04.2012 US 201261639358 P; 18.09.2012 US 201261702640 P
(71) Applicant: Applied Materials Italia Srl, 31048 San Biagio di Callalta (IT)
(72) Inventor: Cellere, Giorgio, 36040 Torri di Quartesolo (VI) (IT); Boscolo Marchi, Enrico, 30015 Chioggia (VE) (IT); Voltan, Alessandro, 31050 Morgano (TV) (IT); Villalta, Alberto, 31045 Motta di Livenza (TV) (IT); De Santi, Luigi, 31027 Spresiano (TV) (IT); Vercesi, Tommaso, 31057 Silea (TV) (IT); Galiazzo, Marco, 35127 Padova (IT)
(74) Representative: Petraz, Gilberto Luigi

(57) **Abstract**

Embodiments of the present invention provide methods for closed-loop control utilized in printing a multilayer pattern on a substrate. In one embodiment, a solar cell formation process is provided. The process comprises positioning a substrate on a substrate receiving surface of a printing station, printing a first patterned layer on a region of the substrate, acquiring a first optical image of the first patterned layer and storing the first optical image in a buffer, printing a second patterned layer over the region of the substrate, wherein the second patterned layer is aligned over the region of the substrate using information received from the acquired first optical image.

## Description

### CROSS-REFERENCE TO RELATED APPLICATIONS:

This application claims benefit of Italian Patent Application No. UD 2011A000171 (Attorney Docket No. 16728/ITAL), filed October 24, 2011, United States provisional patent application Serial No. 61/639,358 (Attorney Docket No. 16728USL), filed April 27, 2012, and United States provisional patent application Serial No. 61/702,640 (Attorney Docket No. 16728USL02), filed September 18, 2012, each of the aforementioned patent applications are hereby incorporated by reference herein.

### BACKGROUND OF THE INVENTION

### Field of the Invention

Embodiments of the present invention generally relate to methods and apparatus for forming a patterned layer on desired regions of a surface of a substrate. In particular, the methods according to the present invention can be used in a system for producing multilayer patterns by means of multilayer printing on a substrate, whether it be by silk-screen printing, ink-jet printing, laser printing or other similar type of printing.

### Description of the Related Art

Solar cells are photovoltaic (PV) devices that convert sunlight directly into electrical power. The PV market has experienced growth at annual rates exceeding 30% for the last ten years. Some articles suggest that solar cell power production world-wide may exceed 10 GWp in the near future. It is estimated that more than 95% of all solar modules are silicon wafer based. The high market growth rate in combination with the need to substantially reduce solar electricity costs has resulted in a number of serious challenges for inexpensively forming high quality solar cells. Therefore, one major component in making commercially viable solar cells lies in reducing the manufacturing costs required to form the solar cells by improving the device yield and increasing the substrate throughput.

Solar cells typically have one or more p-n junctions. Each p-n junction comprises two different regions within a semiconductor material where one side is denoted as the p-type region and the other as the n-type region. When the p-n junction of a solar cell is exposed to sunlight (consisting of energy from photons), the sunlight is directly converted to electricity through the PV effect. Solar cells generate a specific amount of electric power and are tiled into modules sized to deliver the desired amount of system power. Solar modules are joined into panels with specific frames and connectors. Solar cells are commonly formed on silicon substrates, which may be single or multicrystalline silicon substrates. A typical solar cell includes a silicon wafer, substrate, or sheet typically less than about 0.3 mm thick with a thin layer of n-type silicon on top of a p-type region formed on the substrate.

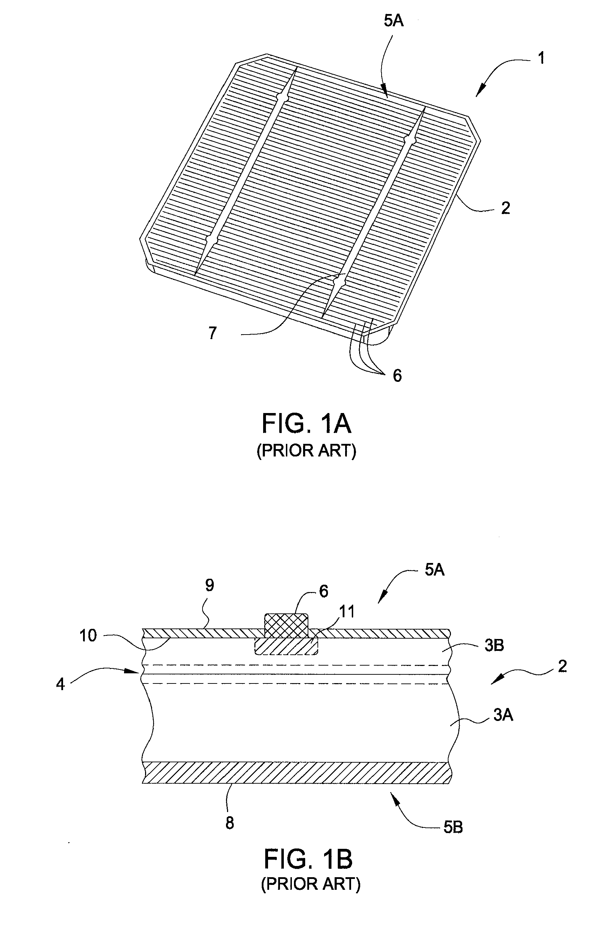

Figures 1A and 1B schematically depicts a standard silicon solar cell 1 fabricated on a wafer 2. The wafer 2 includes a p-type base region 3A, an n-type emitter region 3B, and a p-n junction region 4 disposed therebetween. The n-type region, or n-type semiconductor, is formed by doping the semiconductor with certain types of elements (*e.g*., phosphorus (P), arsenic (As), or antimony (Sb)) in order to increase the number of negative charge carriers, *i.e*., electrons. Similarly, a p-type region, or p-type semiconductor, is formed by the addition of trivalent atoms to the crystal lattice, resulting in a missing electron from one of the four covalent bonds normal for the silicon lattice. Thus the dopant atom can accept an electron from a neighboring atoms covalent bond to complete the fourth bond. The dopant atom accepts an electron, causing the loss of half of one bond from the neighboring atom and resulting in the formation of a "hole".

When light falls on the solar cell, energy from the incident photons generates electron-hole pairs on both sides of the p-n junction region 4. Electrons diffuse across the p-n junction to a lower energy level and holes diffuse in the opposite direction, creating a negative charge on the emitter and a corresponding positive charge builds up in the base. When an electrical circuit is made between the emitter and the base and the p-n junction is exposed to certain wavelengths of light, a current will flow. The electrical current generated by the semiconductor when illuminated flows through contacts disposed on the frontside 5A, *i.e.* the light-receiving side, and the backside 5B of the solar cell 1. A top contact structure, as shown in Figure 1A, is generally configured as widely-spaced thin metal lines, or fingers 6, that supply current to a larger bus bar 7. A back contact 8 is generally not constrained to be formed in multiple thin metal lines, since it does not prevent incident light from striking the solar cell 1. The solar cell 1 is generally covered with a thin layer of dielectric material, such as Si₃N₄, to act as an anti-reflection coating 9, or ARC, to minimize light reflection from a top surface 10 of solar cell 1.

Screen printing has long been used in printing designs on objects, such as cloth or ceramics, and is used in the electronics industry for printing electrical component designs, such as electrical contacts or interconnects on the surface of a substrate. State of the art solar cell fabrication processes also use screen printing processes. In some applications, it is desirable to screen print contact lines, such as fingers 6, on the solar cell substrate. The fingers 6 are in contact with the substrate are adapted to form an Ohmic connection with one or more doped regions (*e.g*., n-type emitter region 3B). An Ohmic contact is a region on a semiconductor device that has been prepared so that the current-voltage (I-V) curve of the device is linear and symmetric, *i.e*., there is no high resistance interface between the doped silicon region of the semiconductor device and the metal contact. Low-resistance, stable contacts are critical for the performance of the solar cell and reliability of the circuits formed in the solar cell fabrication process.

A heavily doped region 11 may be formed on the substrate surface using a variety of patterning techniques to create areas of varied doping, for example by performing phosphorus diffusion steps using a patterned diffusion barrier. A backside contact completes the electrical circuit required for solar cell to produce a current by forming an Ohmic contact with p-type base region of the substrate. To enhance the contact with the solar cell device it is typical to position a finger 6 on the heavily doped regions 11 formed within the substrate surface to enable the formation of an Ohmic contact. Since the formed heavily doped regions 11, due to their electrical properties, tend to block or minimize the amount light that can pass there through it is desirable to minimize their size, while also making these regions large enough to assure that the fingers 6 can be reliably aligned and formed thereon.

Formation of the heavily doped region 11 and the finger 6 may comprise deposition of multiple, successive layers of material. The misalignment of the layers forming the heavily doped region 11 may cause the surface area of the heavily doped region to be larger than what is necessary and prevent passage of light that would otherwise be available to the solar cell. Additionally, misalignment of the deposited fingers 6 to the underlying heavily doped regions 11 can lead to poor device performance and low device efficiency. The misalignment in the formation of the heavily doped region 11 and the finger 6 may be due to errors in the positioning of the substrate on an automated transferring device, defects in the edge of the substrate, unknown registration and alignment of the heavily doped region 11 on the substrate surface and/or shifting of the substrate on the automated transferring device. Consequently, in the event of a large enough error during a printing process step, the misalignment of the printed multiple layers will cause the substrate to be discarded.

Alignment of these layers is typically determined and/or provided by alignment markers on the substrate and/or detecting different printed regions only in the previous print and the subsequent print. The latter may be obtained using different nets or masks which determine the desired final pattern, but form different printing patterns that overlap individually for each printing step. However, once a given subsequent layer has been printed on the lower, or previous, layer, it is particularly difficult to know exactly the actual position of the successive layers printed because, they are partly or completely obscured by the previous layers Furthermore, using different printing nets or masks in specific regions for the purposes of alignment as above, in practice it is not possible to have the double print (*i.e*., form one layer on another layer) on the substrate, which reduces the performance of the substrate. Moreover, the use of alignment markers may mask part of the active surface of the substrate, in this case too reducing the performance thereof.

It must also be noted that the use of different printing nets or masks for the purposes of alignment as described above can lead to aesthetic problems with printed pattern, such as the color or quality of the print, (*i.e*., height and/or width of the fingers), due to the different materials normally used in subsequent prints. Conversely, identical printing nets or masks may be used in order to make the final color uniform. However, it is not possible, with known control methods, to discriminate the positions of the various superimposed printed layers, since the various printed layers are superimposed one on top of the other. Furthermore, in this case, there is the disadvantage that the print covers any markers used and printed in the previous printing step.

Therefore, there is a need for an apparatus for the production of solar cells, electronic circuits, or other useful devices, that has improved methods of controlling the alignment of the patterned layers to heavily doped regions 11 and/or form metal feature(s) (*e.g*., fingers 6) on a heavily doped region using a screen printing or other similar process.

### SUMMARY OF THE INVENTION

Embodiments of the present invention provide apparatus and methods for closed-loop control utilized in printing a multilayer pattern on a substrate. In one embodiment, a solar cell formation process is provided. The process comprises positioning a substrate on a substrate receiving surface of a first printing station, printing a first patterned layer on a region of the substrate, acquiring a first image of the first patterned layer and storing the first image in a buffer, transferring the substrate to a substrate receiving surface of a second printing station, and printing a second patterned layer over the region of the substrate, wherein the second patterned layer is aligned over the region of the substrate using information received from the acquired first image.

In another embodiment, a solar cell formation process is provided. The process comprises positioning a substrate on a substrate receiving surface of a printing station, printing a first patterned layer on a region of the substrate, acquiring a first optical image of the first patterned layer, printing a second patterned layer over the region of the substrate, wherein the second patterned layer is aligned over the region of the substrate using information received from the acquired first optical image, acquiring a second optical image of the second patterned layer, and printing a third patterned layer over the second patterned layer, wherein the third patterned layer is aligned over the second patterned layer using information received from the acquired first optical image or the acquired second optical image.

In another embodiment, a solar cell formation process is provided. The process comprises positioning a substrate on a substrate receiving surface of a first printing station, printing a first patterned layer on a region of the substrate, acquiring a first image of the first patterned layer, transferring the substrate to a substrate receiving surface of a second printing station, printing a second patterned layer over the region of the substrate, wherein the second patterned layer is aligned over the region of the substrate using information received from the acquired first image, acquiring a second image of the second patterned layer, and printing a third patterned layer over the second patterned layer, wherein the third patterned layer is aligned over the second patterned layer using information received from the acquired first image or the acquired second image, and the third patterned layer is aligned within about 10 microns relative to the first patterned layer.

In another embodiment, a system for processing a substrate is provided. The system comprises a first printing station comprising a first printing screen and a first actuator coupled to the first printing screen, a second printing station comprising a second printing screen and a second actuator coupled to the second printing screen, a third printing station comprising a third printing screen and a third actuator coupled to the third printing screen, a first control station associated with the first printing station or the second printing station, a second control station associated with the second printing station or the third printing station, wherein each of the first control station and the second control station comprise a detection device and an alignment device, and a central control unit in communication with the first control station and the second control station, wherein the central control unit is configured to alter the position of the first printing screen using the first actuator, second printing screen using the second actuator or third printing screen using the third actuator using information received from an image formed by the detection device in the first control station or the second control station.

In another embodiment, a system for processing a substrate is provided. The system comprises a first printing station comprising a first printing screen and a first actuator coupled to the first printing screen, a second printing station comprising a second printing screen and a second actuator coupled to the second printing screen, a third printing station comprising a third printing screen and a third actuator coupled to the third printing screen, a first control station associated with the first printing station or the second printing station, a second control station associated with the second printing station or the third printing station, wherein each of the first control station and the second control station comprise a detection device and an alignment device, and a central control unit in communication with the first control station and the second control station, wherein the central control unit is configured to alter the relative position of a substrate and the second printing screen or the third printing screen using data calculated from an image acquired by the detection device in the first control station or the second control station.

### BRIEF DESCRIPTION OF THE DRAWINGS

These and other characteristics of the invention will become apparent from the following description of a preferential embodiment, given as a non-restrictive example with reference to the attached drawings wherein:

Figure 1A illustrates an isometric view of prior art solar cell containing a front side metallization interconnect pattern.

Figure 1B illustrates a cross-sectional side view of a prior art solar cell shown in Figure 1A.

Figure 2 is a schematic representation of a method according to the present invention;

Figure 3 shows a flow chart of a multilayer printing process according to the present invention;

Figure 4 is a schematic view of an apparatus for the multilayer printing process according to the present invention;

Figure 5 is a schematic view of a variant of the apparatus in Figure 4;

Figure 6 is plan view of a surface of a substrate that has a heavily doped region and a patterned metal contact structure formed thereon according to one embodiment of the invention;

Figure 7 is an enlarged lateral section view along lines 7 - 7 in figure 6;

Figure 8 is an enlarged lateral section view of a portion of the substrate surface shown in figure 6 according to another embodiment of the invention;

Figure 9 is a schematic isometric view of a system that may be used in conjunction with embodiments of the present invention;

Figure 10 is a schematic top plan view of the system in Figure 8 according to one embodiment of the invention;

Figure 11 is a schematic isometric view of another system that may be used in conjunction with embodiments of the present invention;

Figure 12 is a schematic top plan view of the system in Figure 11 according to one embodiment of the invention;

Figure 13 is a schematic isometric view of another system that may be used in conjunction with embodiments of the present invention;

Figure 14 is a schematic top plan view of the system in Figure 13 according to one embodiment of the invention;

Figure 15 is an isometric view of a printing nest portion of the screen printing system according to one embodiment of the invention;

Figure 16 is a schematic isometric view of one embodiment of a rotary actuator assembly having an inspection assembly positioned to inspect the front surface of the substrate according to one embodiment of the invention;

Figure 17 is a schematic cross-sectional view of a optical inspection system according to one embodiment of the invention

Figure 18 is a schematic cross-sectional view of an optical inspection system positioned in a printing nest according to one embodiment of the invention.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments of the present invention provide apparatus and methods for closed-loop control utilized in printing a multilayer pattern on a substrate. In one embodiment, a system is provided for closed-loop control of a multilayer printing process on a substrate. The system may be a screen printing system that is adapted to perform a screen printing process within a portion of a crystalline silicon solar cell production line in which a substrate is patterned with a desired material and is then processed in one or more subsequent processing chambers. The subsequent processing chambers may be adapted to perform one or more thermal processing steps and one or more cleaning steps. In one embodiment, the system is a module positioned within the Soft Line tool available from Baccini S.p.A., which is owned by Applied Materials, Inc. of Santa Clara, California. While the discussion below primarily discusses the processes of screen printing a pattern, such as an interconnect or contact structure, on a surface of a solar cell device this configuration is not intended to be limiting as to the scope of the invention described herein. Other substrate materials that may benefit from the invention include substrates that may have an active region that contain single crystal silicon, multi-crystalline silicon, polycrystalline silicon, or other desirable substrate materials.

Embodiments of the invention may provide a method that comprises printing of a first patterned layer on a substrate in a first printing station. The method also includes acquiring a first image of the first patterned layer on the substrate, and the coordinates of the position of the first patterned layer on the substrate associated therewith is stored in a specific buffer. The method also includes preparing the substrate for a second patterned layer to be printed on the first patterned layer. Preparation may include transferring the substrate to a second printing station, and printing the second patterned layer on the first patterned layer. Preparation may also include printing the second patterned layer on the first patterned layer in the first printing station. The second image may be compared with the stored first image in order to determine alignment of the second patterned layer relative to the first patterned layer. The method may also include acquiring at least a second or subsequent image of a second or subsequent patterned layer and uses the first image memorized or stored, and the coordinates of the position of the first patterned layer on the substrate associated therewith using a closed-loop feedback control. The memorization of images as used herein includes storage of analog data, digital data, and combinations thereof. The method may also include acquiring a second image of the second patterned layer after printing of the second patterned layer on the first patterned layer. In one aspect, a calculation step is performed by a system controller utilizing the first image stored in the specific buffer and the second image.

The calculation step determines the overlap of the second patterned layer with the first patterned layer. If misalignment between the first patterned layer and the second patterned layer is determined, the method also includes a correction step that is utilized on subsequent substrates having the first patterned layer printed thereon. The correction step is based on the calculation step, wherein one or more subsequent substrates having a first patterned layer disposed thereon are prepared for a second patterned layer to be printed on the first patterned layer. The correction step may include adjusting the position of the substrate, if necessary, to deposit the second patterned layer on the substrate. The second patterned layer may be printed in the first printing station or a second printing station. The correction step may also include determining the position of the each of the subsequent substrates in the first printing station or the second printing station, and adjustment of the position of the substrate, if necessary, is performed prior to printing of the second patterned layer on the substrate.

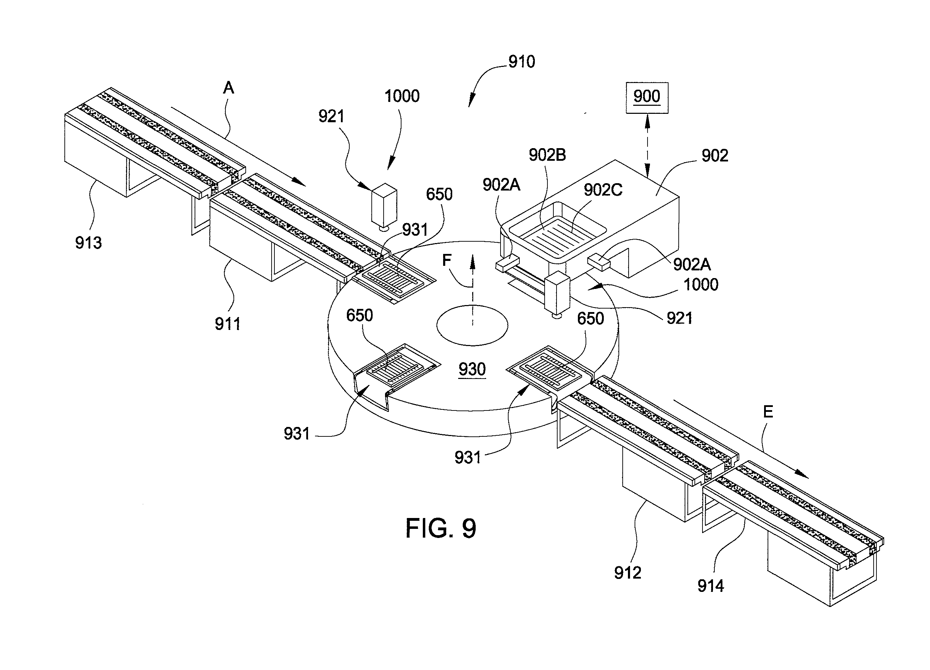

In some embodiments, each of the subsequent substrates may be positioned on a printing nest (*i.e*., a substrate shuttle) for transfer into a second printing station for printing of the second patterned layer on the first patterned layer. The correction step may also include adjusting the position of the printing nest to assure the subsequent substrates are aligned prior to printing of the second patterned layer thereon. The correction step may also include adjusting the position of a print screen or mask prior to printing of the second patterned layer on the first patterned layer by use of one or more actuators (e.g., reference numerals 902A-902B in Figures 9-10) that are disposed in the printing station.

Embodiments of the method may be utilized to adjust and correct the printing of the second or subsequent patterned printed layer on multiple substrates in series or parallel, and provides a precise alignment of the printed layers on these substrates. The control method as described herein can therefore improve the device yield performance and the cost of ownership (CoO) of a substrate processing line.

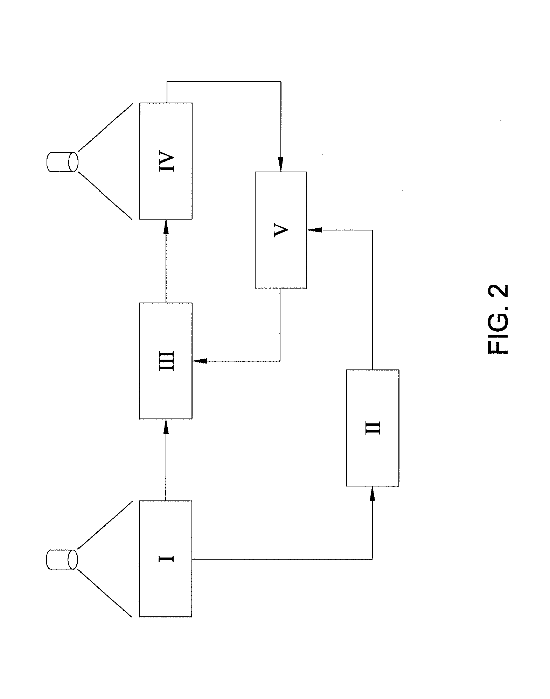

A schematic representation of the method is given in Figure 2, in which block I indicates a first acquisition of a first image of a first printed layer in a first printing step to detect the coordinates of the position of the first printed layer. Block II indicates a step of memorizing at least the first image acquired and the coordinates of the position of the first patterned layer on the substrate associated therewith. Block III indicates a second printing step of a second patterned layer printed on the first printed layer. Block IV indicates a second direct acquisition of an image of a second layer printed on the first layer, block V indicates a verification step in which a closed-loop feedback control calculation is performed, using the first image memorized (*i.e*., stored) in block II and associated with the coordinates of the position of the first printed layer, to adjust or correct the second printing step.

In one embodiment, a screen printing system is used, that is adapted to perform a screen printing process according to the present invention within a portion of a crystalline silicon solar cell production line in which a substrate is patterned with a desired material and is then processed in one or more subsequent processing chambers. The subsequent processing chambers may be adapted to perform one or more bake steps and one or more cleaning steps.

While the previous discussion primarily focuses on the processes of screen printing a pattern, such as a contact pattern or an interconnect structure pattern, on a surface of a solar cell device, this configuration is not intended to be limiting as to the scope of the invention described. Other substrate materials that may benefit from the invention include substrates that may have an active region that contain single crystal silicon, multi-crystalline silicon, polycrystalline silicon or other desirable substrate materials.

### Method to print a multilayer pattern on a substrate

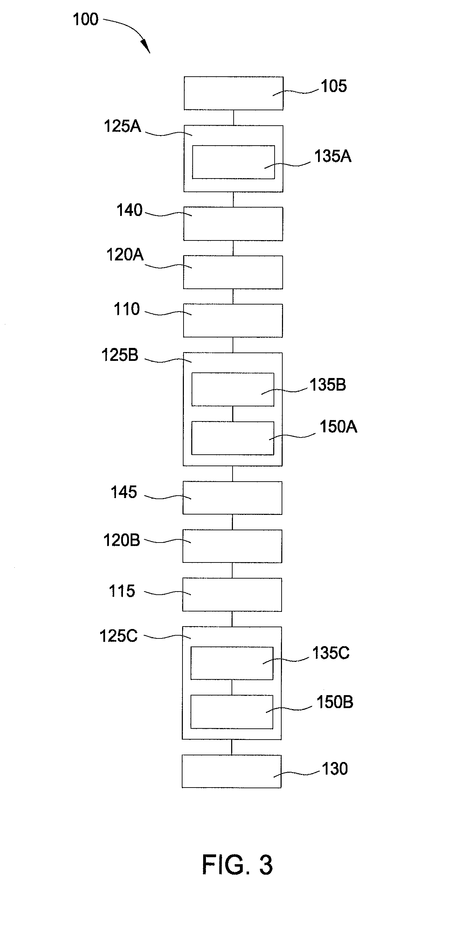

Figure 3 depicts another embodiment of a method 100 for forming multiple patterns on a substrate according to the invention. The method 100 comprises at least a first printing step 105 to form a first patterned layer on the substrate, a second printing step 110 and a third printing step 115 for forming additional patterned layers on the substrate. Alignment steps 120A, 120B are also provided to align the substrate during the performance of the method 100. Alignment step 120A may be performed between the first printing step 105 and the second printing step 110. Alignment step 120B may be performed between the second printing step 110 and the third printing step 115. The method 100 also includes verification steps 125A, 125B, 125C (*e.g*., control operations) to determine the precision of the alignment of the substrate that may be performed after the first printing step 105, the second printing step 110, and the third printing step 115. The method 100 also includes a discharge step 130 where the printing process is complete and the substrate may be transferred into another processing environment. It is clear that the same description applies, suitably modified, for methods which provide more than three printing steps, and also to more simple cases with two printing steps.

In some embodiments of the present invention, each verification step 125A, 125B, 125C comprises operations that are performed both upstream (*e.g*., before) and downstream of (*e.g*., after) corresponding printing steps. For example, acquisition steps 135A, 135B comprise acquiring an optical image of the first patterned layer printed on the substrate, performed after the correlated printing step 105, 110 and before a further printing step 110, 115, to detect the coordinates of the position of the first patterned layer printed on the substrate. Memorization steps 140, 145 comprise memorizing (*i.e*., storing) the optical image acquired in the acquisition steps 135A, 135B and the coordinates of the position of the first patterned layer on the substrate associated therewith. A further acquisition step 135B, 135C, comprising acquiring additional optical images of the further patterned layer printed on the first layer, may be performed after one or both of the second printing step 110 and the third printing step 115.

The method 100 may include a first closed-loop feedback calculation step 150A and a second closed-loop feedback calculation step 150B. The first and second closed-loop feedback calculation steps 150A, 150B comprise using the coordinates of the position of the first patterned printed layer detected by the optical image stored during the memorization operation 140, 145, and may be used to adjust or correct the printing alignment of the second patterned printed layer on the first patterned layer. An optical image includes an image detected with light in the visible range, as well as an image detected with light in the infrared range or other wavelength.

The calculation steps 150A and 150B may be performed in a system controller, wherein the coordinates of the first patterned layer and the coordinates of the second patterned layer printed on the first patterned layer are compared. For example, the coordinates of one or both or the first patterned layer and the second patterned layer are stored (*i.e*., memorized) as data which resembles two rectangles. In this example, the vertices of each rectangle, corresponding to the first patterned layer and the second patterned layer, are compared. If the vertices are aligned or overlapped optimally, the calculation step is ceased, and subsequent substrates having the first patterned layer printed thereon are processed by printing of a second patterned layer on the first patterned layer without adjustment. However, where the X-Y offset between the vertices is sub-optimal, the offset is calculated and appropriate corrective instructions are utilized in the alignment steps 120A, 120B to correct the X-Y offset during printing of the second patterned layer printed on the first patterned layer printed on subsequent substrates.

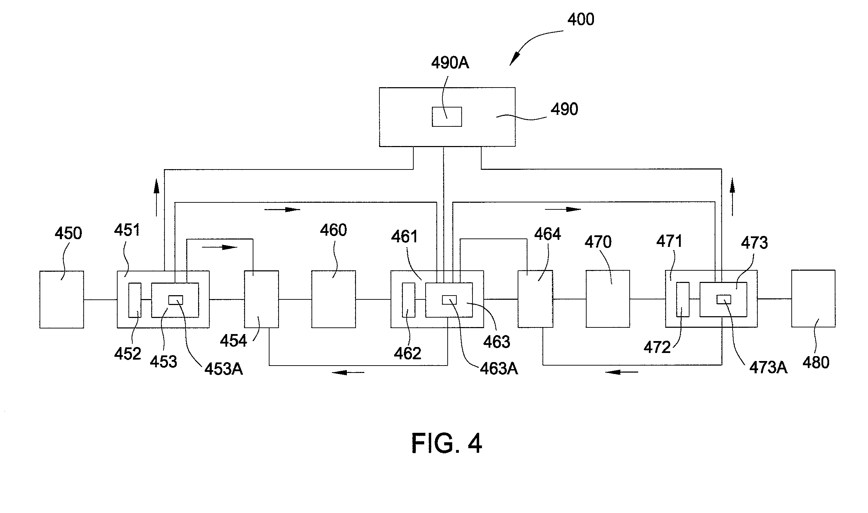

Figure 4 shows schematically a possible embodiment of a system 400 that is able to carry out the method shown in Figures 2 and 3. The system 400 may comprise, in succession, a first printing station 450, a first control station 451, first alignment devices 454, a second printing station 460, a second control station 461, second alignment devices 464, a third printing station 470, a third control station 471, a discharge station 480 and a central control and data processing unit 490. A quality control station (not shown) may also be coupled to the system 400 or quality control is continually monitored using the data from one or more of the control stations 451, 461, 471. In one embodiment, each control station 451, 461, 471 comprises detection devices 452, 462, 472 and a command and control unit 453, 463, 473, respectively. In Fig. 4, the arrows indicate the directions of the data flows between the various parts of the system 400.

According to the present invention, in the first printing step 105 the silk-screen printing is carried out on a surface of a substrate, for example a silicon based wafer, to form a first layer of a multilayer pattern, in correspondence with the first printing station 450 in which the substrate is fed by means of known feed systems, such as robotic equipment and/or a conveyor system.

Downstream of the first printing step 105, some embodiments of the method according to the present invention provide a first operation (*i.e*., verification step 125A) of acquiring a first optical image of the first patterned layer printed on the substrate, by means of a first detection device 452, identifying the coordinates of the position thereof on the substrate. The first image, and the coordinates of the position of the first patterned layer on the substrate associated therewith, is memorized in a first electronic memory 453A of the first command and control unit 453 of the first control station 451 and possibly transmitted to a second command and control unit 463 of the second control station 461, or directly transmitted and stored in a central electronic memory 490A of the central control and data processing unit 490, according to operating modes.

The information on the coordinates of the position of the first patterned layer detected with the first image can be sent to the first alignment devices 454. The first acquisition operation 135A may be followed by a first alignment step 120A in which, in relation to the position of the first printed layer, the first alignment devices 454, for example thrusters, which may be pneumatic, hydraulic or mechanical actuators, position the substrate correctly for the execution of the second printing step 110.

In another form of embodiment, the correct positioning of the substrate is achieved by the aligning device, such as a thruster as described above, for moving the substrate below the printing heads present in the second printing station 460. The first alignment devices 454 can also include actuators for positioning the printing heads present in the second printing station 460.

After the second printing step 110, in which a second layer of the pattern is printed on the substrate, above the first layer, the present invention provides a second operation (*i.e*., verification step 125B) to acquire a second optical image of the second patterned layer printed on the substrate together with the first layer, by means of a second detection device 462.

The second image may only be acquired, or can be stored in a second electronic memory 463A of the second command and control unit 463 of the second control station 461 and possibly transmitted to a third command and control unit 473 of the third control station 471, or directly transmitted and stored in the central electronic memory 490A of the central control and data processing unit 490, according to operating modes.

Furthermore, the second command and control unit 463 of the second control station 461 carries out a first closed-loop feedback calculation step 150A using the coordinates of the position of the first patterned printed layer detected with the first image, compared with the coordinates of the position of the second printed layer associated with the second image acquired directly, and the outcome of the calculation is used to suitably command the first alignment devices 454.

The information concerning the coordinates of the position of the second patterned layer can be sent to the first alignment devices 454. In particular, in the event that said data are not consistent, the second command and control unit 463 of the second control station 461 sends a closed-loop feedback signal to the first alignment devices 454 to communicate the non-consistency, and consequently to adjust or correct the second print.

The second acquisition operation 135B may be followed by a second alignment step 120B in which, in relation to the position of the second printed layer, the second alignment devices 464, for example thrusters, as described above, position the substrate correctly for the execution of the third printing step 31. After the second alignment step 120B, the third printing step 31 and a third verification step 125C are carried out.

In particular, in the third printing step 115, in correspondence with the third printing station 470, a third layer of the pattern is printed, and in the third verification step 125C, a third operation (*i.e*., acquisition step 135C) is performed to acquire a third optical image of the third patterned layer printed on the second layer, in turn printed on the first layer, by means of the third detection device 472.

The third image may only be acquired, or can be stored in a third electronic memory 473A of the third command and control unit 473 of the third control station 471, or stored in the central electronic memory 490A of the central control and data processing unit 490, according to operating modes.

Moreover, in the third verification step 125C, the third command and control unit 473 of the third control station 471 performs a second closed-loop feedback calculation step 150B using the verified coordinates of the position of the second patterned printed layer detected with the second image, compared with the coordinates of the position of the third printed layer associated with the third image acquired directly, and the outcome of the calculation is used to suitably command the second alignment devices 464.

The information concerning the coordinates of the position of the third patterned layer can be sent to the second alignment devices 464. In particular, in the event that said data are not consistent, the third command and control unit 473 of the third control station 471 sends a closed-loop feedback signal to the second alignment devices 464 to communicate the inconsistent alignment.

Each command and control unit 453, 463, 473 also supplies the data detected to the central control and data processing unit 490 which organizes, stores the data collected according to data bases predefined by the user, and processes them in the forms and ways requested by the user, for example statistically, or in such a manner as to identify the critical points of the production process.

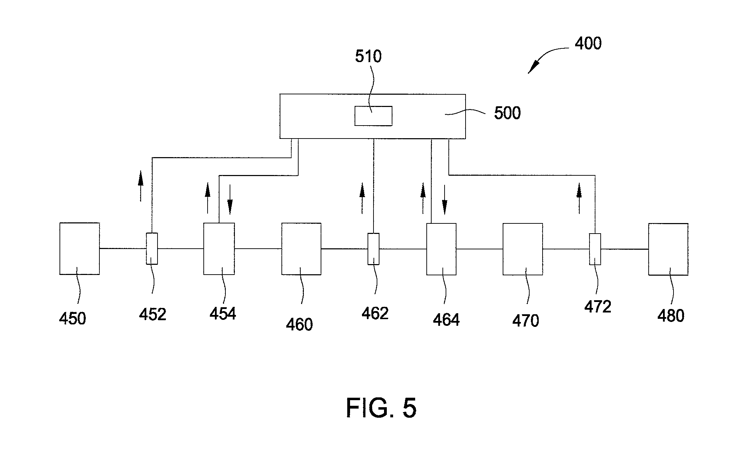

According to a further variant, shown in Fig. 5, all the data transmission sub-steps of data obtained through, for example, acquisition steps 135A-135C and/or verification steps 125A-125C, can be governed by a single central command and control unit 500. The single central command and control unit 500 may be provided with an electronic memory 510 in which to store at least the first image acquired, and possibly, on each occasion, the images subsequently acquired and used in the closed-loop feedback calculation operations as above. In one example, the central command and control unit 500 processes the data arriving from the detection devices 452, 462, 472 downstream of each printing station 450, 460, 470, compares the data according to preset programs, and transmits the control signals to the different alignment devices 454, 464. It is also clear that the central control and data processing unit 490 and 500 as referred above can be, in general, configured as the above-mentioned control units 453, 463, 473.

Memorization at least of the first optical image acquired, from which the coordinates of the position of the first patterned printed layer on a substrate used in the closed-loop feedback control are detected, it is possible, that the second and third deposited layers may be reliably aligned with the first printed patterned layer. In one embodiment, the precision of the placement of the subsequent second and third layers may be on the order of about 10 microns (µm), or less, with respect to the first patterned printed layer. In the screen printing embodiment, the second printing station 460 and the third printing station 470, are each equipped with a screen-printing net or mask, identical to the one in the first printing station 450, which prevents overlap of the subsequent layers and enables double printing. Furthermore, it is not necessary, at least in the first printing step, to print alignment markers or other distinctive recognition and alignment signs that may subsequently be covered by additional layers and which reduce the active surface area of the substrate.

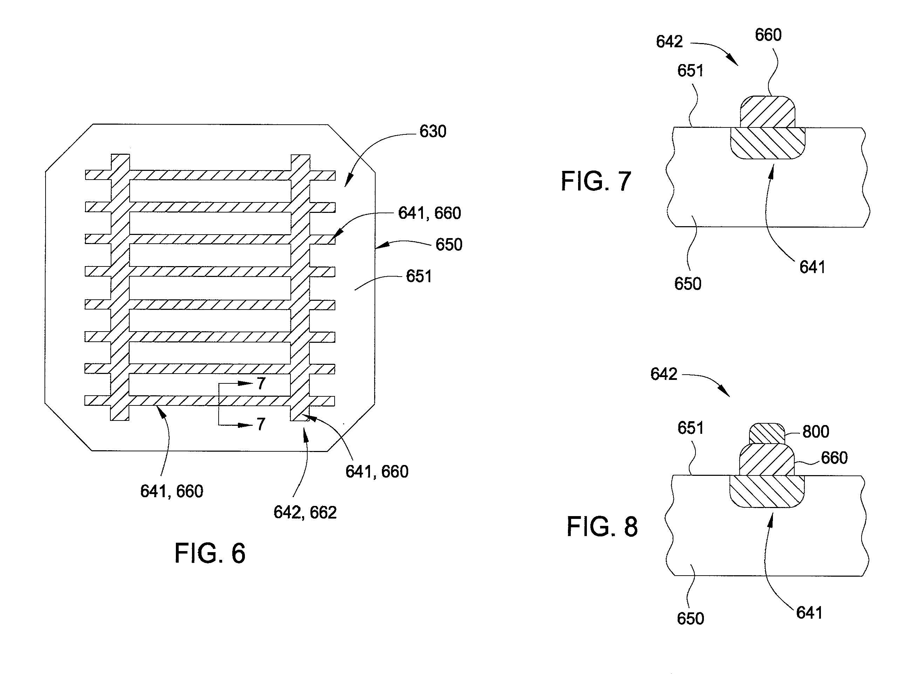

Figure 6 is a plan view of a surface 651 of the substrate 650 that has a multilayer pattern 630 formed thereon. The multilayer pattern 630 comprises a plurality of heavily doped regions 641 formed on the surface 651. The heavily doped regions 641 generally comprise a portion of the substrate 650 material that has about 0.1 atomic percent, or less, of dopant atoms disposed therein. A patterned type of heavily doped regions 641 can be formed by conventional lithographic and ion implantation techniques, or conventional dielectric masking and high temperature furnace diffusion techniques that are known in the art. A patterned metal contact structure 642 may be formed thereon to form a metal finger 660 and/or a busbar 662.

Figure 7 illustrates a portion of the surface 651 of the substrate 650 having a metal finger 660, for example made of silver (Ag), disposed on the heavily doped region 641. The metal contact structure 642, such as the fingers 660 and busbars 662, is formed on the heavily doped regions 641 so that a high quality electrical connection can be formed between these two regions. Low-resistance, stable contacts are critical for the performance of the solar cell. However, the processes of aligning and depositing the metal contact structure 642 on the heavily doped regions 641 is generally not possible using conventional techniques, since there is typically no way to optically determine the actual alignment and orientation of the formed heavily doped region 641 pattern on the surface 651 of the substrate 650 using these techniques.

Figure 8 is a schematic cross-sectional view of a portion of the surface 651 of the substrate 650 having a metal finger 660, for example made of silver (Ag), disposed on the heavily doped region 641. A double printing process may be utilized to form a second patterned layer on the metal finger 660 to form a narrow metal finger structure 800 having a width that is less than a width of the metal finger 660.

Embodiments of the invention, related to the more general printing steps 105, 110, 115 described in Figure 3, may be performed in a solar cell formation process that includes the formation of metal contacts, for example of silver, with double printing, over heavily doped regions 641 that are formed in a desired multilayer pattern 630 on a surface of a substrate 650 (Figures 6 and 7).

A double printing process may be performed, for example to make superimposed fingers having different sizes in width (*e.g*., narrow metal finger structure 800 shown in Figure 8), or superimposed fingers having the same sizes in width but made with different materials or with different functions, or a combination of these two types.

For example, embodiments of the invention provide a double printing mode in which, in the first printing step 105 (Figure 3) a dopant paste is printed to enable the formation of the heavily doped regions 641, in the second printing step 110 (Figure 3) a wide metal line, for example of silver, defining a metal finger 660 (Figures 6 and 7) is printed on the formed heavily doped regions 641 and in the third printing step 115 (Figure 3) a narrow metal line, for example of silver, defining a narrow metal finger structure 800 (Figure 8) is printed on the wide metal line (*e.g*., metal finger 660), forming a metal contact structure 642 with a multilayer pattern 630 (see Figures 6, 7 and 8). One will note that one or more thermal processing steps may be performed on the substrate in the system (e.g., system 400) between each of the printing steps (*e.g*., steps 105, 110 and 115) to further process the printed layers, such as driving in the dopant atoms in the dopant paste to form the heavily doped regions 641 and/or densifying and forming a good electrical contact between a metal material found in the second and third printed layers and the substrate surface (e.g., heavily doped regions 641).

In other embodiments, a double printing mode may be used after the first printing step 105 to form a metalized layer from a contact paste (*e.g*., to form metal fingers 660 in the second printing step 110), and the following third printing step 115 provides a printing to form a metalized layer from a conductive paste different than the contact paste (*e.g*., to form the narrow metal finger structure 800). The conductive paste and the contact paste may both comprise metal, for example a metal that is silver-based.

According to embodiments of the invention, as will be more precisely described below, one or more, or each, of the printing stations 450, 460, 470 described in Figure 4 can be configured as a printing system 910 described in connection with Figures 9-14.

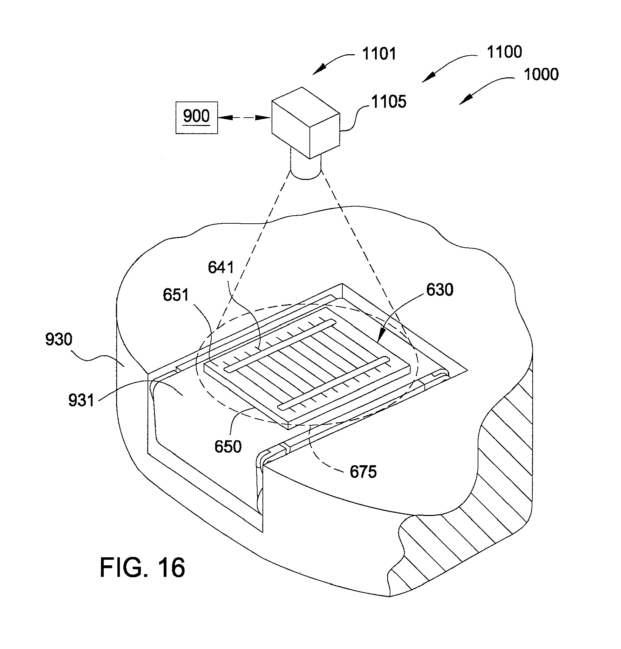

Moreover, the control stations 451, 461, 471 described in Figure 4, that are provided with detection device 452, 462, 472 and control units 453, 463, 473, can be configured as an inspection system 400 described below in connection with Figures 16-18 associated with a system controller 900 exemplified in Figures 9, 10, 13, 14, 16 and 17. In particular, control units 453, 463, 473 can be configured as the system controller 900 described hereinafter.

Furthermore, the above-mentioned alignment device 454, 464 shown in Figure 4 can be configured as actuators 902A described below in connection with printing chamber 902 of Figures 9-14.

Embodiments of the invention, related to the more general control steps (*e.g*., verification steps 125A, 125B, 125C) and alignment steps 120A, 120B described in Figure 3, specifically also provide an inspection system and supporting hardware that are used to reliably position a similarly shaped, or patterned, metal contact structure on the patterned heavily doped regions to allow an Ohmic contact to be made.

### Screen-printing system

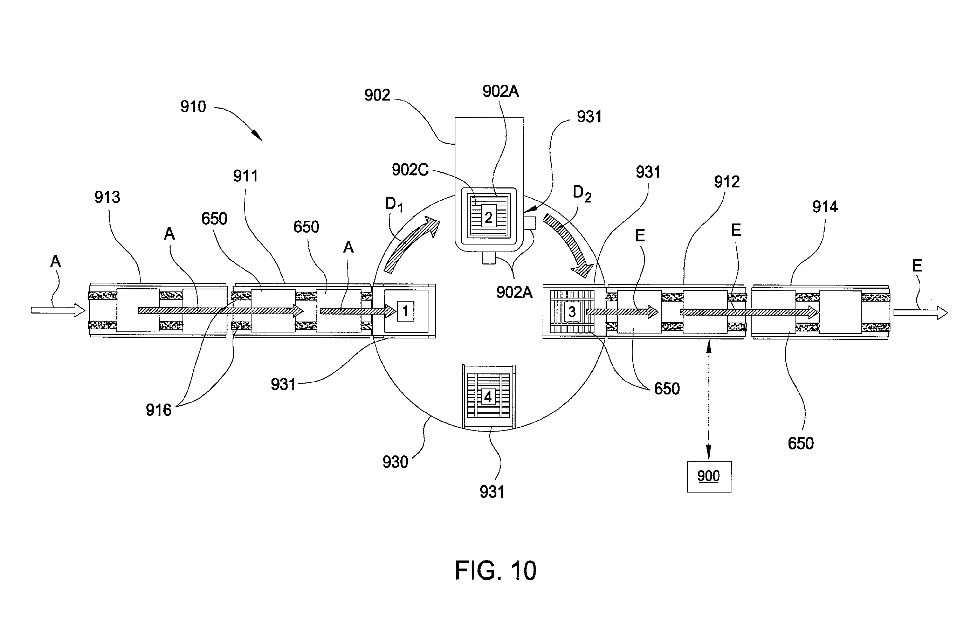

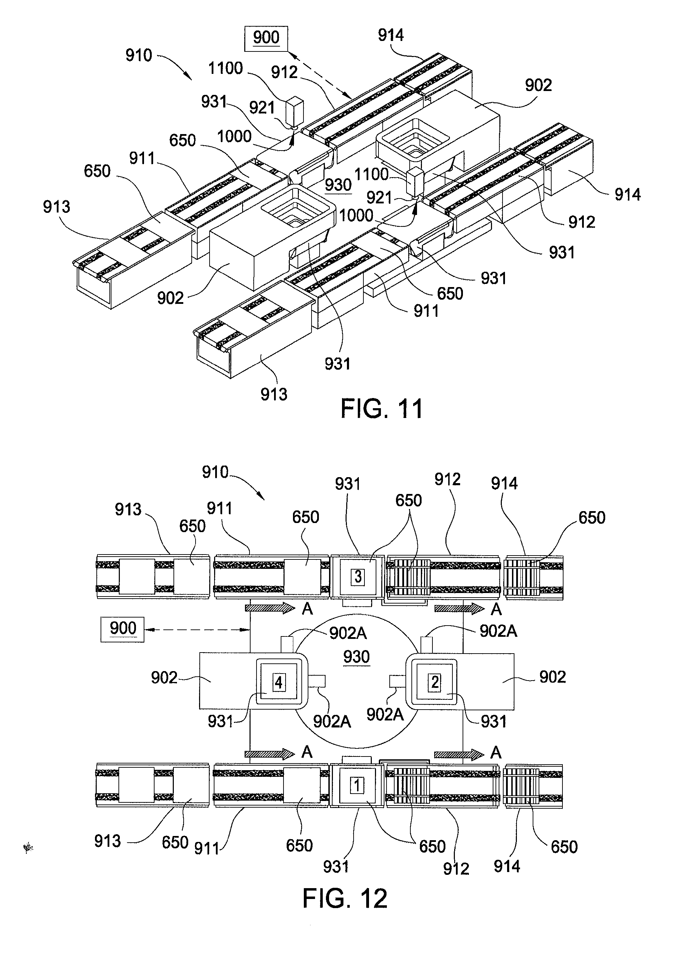

According to a further aspect of the invention, Figure 9 is a schematic isometric view and Figure 10 is a schematic top plan view illustrating one embodiment of a screen printing system 910 that may be used as one or more of the printing stations 450, 460, 470 of the system 400 of Figures 4 and 5. The screen printing system 910 may be utilized in conjunction with embodiments of the present invention to form the metal contacts in a desired pattern on a surface of a solar cell substrate 650 using an optical inspection system 1100, which is shown in Figure 11 and described in more detail in Figure 16.

In one embodiment, the screen printing system 910 comprises an incoming conveyor 911, an actuator assembly 930, which is configured as a rotary actuator table or rotary transfer device in this embodiment, a screen print chamber 902, and an outgoing conveyor 912. The incoming conveyor 911 may comprise a moving surface 916 that may be configured to receive a substrate 650 from an input device, such as an input conveyor 913 (*i.e*., path "A" in Figure 10), and transfer the substrate 650 to a printing nest 931 coupled to the actuator assembly 930. In one aspect, the printing nest 931 comprises a substrate shuttle that provides positioning of a substrate 650 thereon relative to a print head in the screen print chamber 902. The outgoing conveyor 912 may be configured to receive a processed substrate 650 from a printing nest 931 coupled to the actuator assembly 930 and transfer the substrate 650 to a substrate removal device, such as an exit conveyor 914 (*i.e*., path "E" in Figure 10). The input conveyor 913 and the exit conveyor 914 may be automated substrate handling devices that are part of a larger production line.

The actuator assembly 930 may be rotated and angularly positioned about the "F" axis by a rotary actuator (not shown) and a system controller 900, such that the printing nests 931 may be selectively angularly positioned within the screen printing system 910 (*e.g*., paths "D1" and "D2" in Figure 10). The actuator assembly 930 may also have one or more supporting components to facilitate the control of the printing nests 931 or other automated devices used to perform a substrate processing sequence in the screen printing system 910.

In one embodiment, the actuator assembly 930 includes four printing nests 931, or substrate supports, that are each adapted to support a substrate 650 during the screen printing process performed within the screen print chamber 902. Figure 10 schematically illustrates the position of the actuator assembly 930 in which one printing nest 931 is in position "1" to receive a substrate 650 from the incoming conveyor 911, another printing nest 931 is in position "2" within the screen print chamber 902 so that another substrate 650 can receive a screen printed pattern on a surface thereof, another printing nest 931 is in position "3" for transferring a processed substrate 650 to the outgoing conveyor 912, and another printing nest 931 is in position "4", which is an intermediate stage between position "1" and position "3".

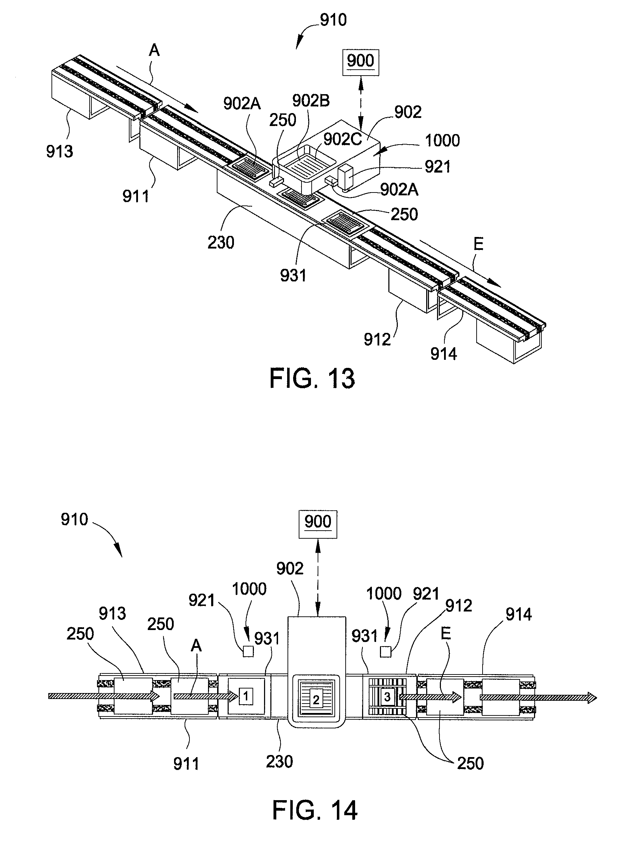

The screen print chamber 902 is adapted to deposit material in a desired pattern on the surface of a substrate 650 positioned on a printing nest 931 in position "2" during the screen printing process. In one embodiment, the screen print chamber 902 includes a plurality of actuators, for example, actuators 902A (*e.g*., stepper motors or servomotors) that are in communication with the system controller 900 and are used to adjust the position and/or angular orientation of a screen printing mask 902B (Figures 9 and 13) disposed within the screen print chamber 902 with respect to the substrate 650 being printed. In another embodiment, the printing nest 931 may be utilized to position the substrate 650 relative to the screen printing mask 902B based on instructions from the system controller 900. The printing nest 931 may be utilized to move the substrate 650 radially (towards or away from the F axis of the actuator assembly 930). The actuator assembly 930 may also be rotated about the F axis to adjust the angular position of the printing nest 931 (and the substrate 650 positioned thereon). Positioning of the printing nest 931 and substrate 650 may be based on calculations performed in the system controller 900 based on acquired images of the substrate 650, or a screen printed layer on the substrate 650.

In one embodiment, the screen printing mask 902B is a metal sheet or plate with a plurality of features 902C (Figures 9 and 13), such as holes, slots, or other apertures formed therethrough to define a pattern and placement of screen printed material (*i.e*., ink or paste) on a surface of a substrate 650. In general, the screen printed pattern that is to be deposited on the surface of a substrate 650 is aligned to the substrate 650 in an automated fashion by orienting the screen printing mask 902B in a desired position over the substrate surface using the actuators 902A and information received by the system controller 900 from the inspection assembly 1000. In one embodiment, the screen print chamber 902 is adapted to deposit a metal containing or dielectric containing material on a solar cell substrate 650 having a width between about 125 mm and 156 mm and a length between about 70 mm and about 156 mm. In one embodiment, the screen print chamber 902 is adapted to deposit a metal containing paste on the surface of the substrate 650 to form the metal contact structure on a surface of a substrate 650.

The system controller 900 facilitates the control and automation of the overall screen printing system 910 and may include a central processing unit (CPU) (not shown), memory (not shown), and support circuits (or I/O) (not shown). The CPU may be one of any form of computer processors that are used in industrial settings for controlling various chamber processes and hardware (e.g., conveyors, optical inspection assemblies, motors, fluid delivery hardware, etc.) and monitor the system and chamber processes (e.g., substrate position, process time, detector signal, etc.). The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the system controller 900 determines which tasks are performable on a substrate. Preferably, the program is software readable by the system controller 900, which includes code to generate and store at least substrate positional information, the sequence of movement of the various controlled components, substrate optical inspection system information, and any combination thereof. In one embodiment of the present invention, the system controller 900 includes pattern recognition software to resolve the positions of heavily doped regions 641 (Figures 6-8) and/or alignment marks, if present. The system controller 900 also includes pattern recognition software to resolve the positions of patterned layers that are formed on the heavily doped regions 641.

Figure 11 is an isometric schematic view and Figure 12 is a top plan schematic view depicting another embodiment of a screen-printing system, or system 910, that can be used as one or more of the printing stations 450, 460, 470 of the system 400 in Figures 4 and 5. The screen printing system 910 may be utilized in conjunction with embodiments of the present invention to form the metal contacts according to a desired pattern on a surface of a solar cell substrate 650 using an optical inspection system 1100 described in more detail in Figures 16-18.

In one embodiment, the system 910 in Figures 11 and 12 generally comprises two incoming conveyors 911 and an actuator assembly 930 that is configured as a linear actuator or conveyor in the embodiment shown in Figure 11 and a rotary table or rotary actuator in Figure 12. The system 910 also includes a plurality of printing nests 931, a plurality of screen print chambers 902, two outgoing conveyors 912, and a system controller 900. The incoming conveyors 911 are configured in a parallel processing configuration so that each can receive unprocessed substrates 650 from an input device, such as an input conveyor 913, and transfer each unprocessed substrate 650 to a printing nest 931 coupled to the actuator assembly 930. In addition, the outgoing conveyors 912 are configured parallel so that each can receive a processed substrate 650 from a printing nest 931 and transfer each processed substrate 650 to a substrate removal device, such as an exit conveyor 914.

In one embodiment, the screen-printing system 910 in Figures 11 and 12 has two printing nests 931 (in positions "1" and "3") each positioned both to transfer a processed substrate 650 to the outgoing conveyor 912 and also to receive a non-processed substrate 650 from the incoming conveyor 911.

Thus, in the system 910 in Figures 11 and 12, the movement of the substrate generally follows the path "A". In this configuration, each of the two other printing nests 931 (in positions "2" and "4") is positioned under a screen-printing chamber 902, so that screen-printing can be carried out on the non-processed substrates 650 located on the respective printing nests 931.

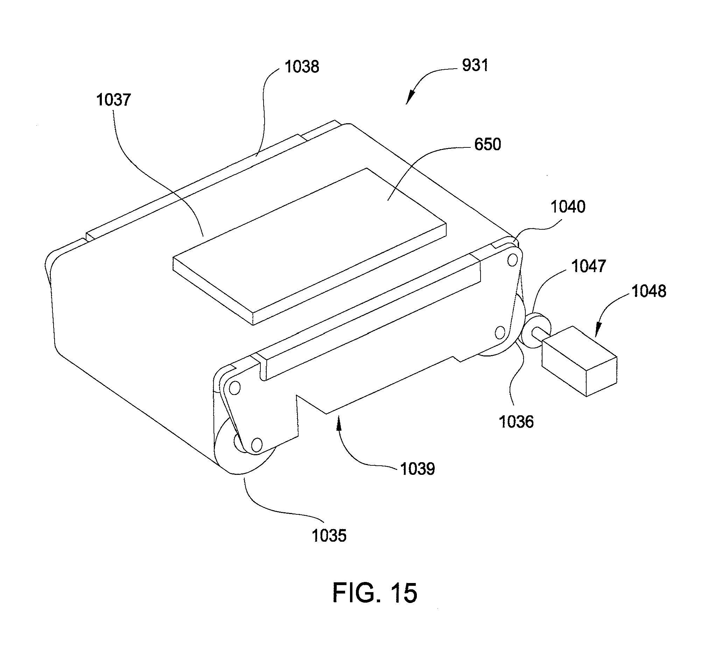

This parallel processing configuration allows an increase in productive capacity with a minimum bulk of the processing system. Although the system 910 is illustrated in Figures 11 and 12 with two screen-printing chambers 902 and four printing nests 931, the system 910 can comprise additional screen-printing chambers 902 and/or printing nests 931, without departing from the field of the present invention. In one embodiment, actuators (e.g., reference numeral 1048 (Figure 15)) in the printing nests 931 may be utilized to position the substrate 650 relative to the screen-printing chambers 902 based on instructions from the system controller 900. The printing nest 931 may be utilized to move the substrate 650 radially (towards or away from the center of the actuator assembly 930). Additionally or alternatively, each printing nest 931 may be independently movable in the X and Y directions, as well as rotationally, to position the substrate 650 within the screen-printing chambers 902 prior to a printing process. Positioning of the printing nest 931 and substrate 650 may be based on calculations performed in the system controller 900 based on acquired images of the substrate 650.

Figure 13 is an isometric schematic view and Figure 14 is a top plan schematic view which show another embodiment of a screen-printing system, or system 910, which can be used as one or more of the printing stations 450, 460, 470 of the system 400 in Figures 4 and 5. The screen printing system 910 may be utilized in conjunction with embodiments of the present invention to form the metal contacts according to a desired pattern on a surface of a solar cell substrate 650 using an optical inspection system 1100 (not shown), which is described in more detail in Figures 16-18.

In one embodiment, the screen-printing system 910 in Figures 13 and 14 comprises an incoming conveyor 911, an actuator assembly 930, which is configured as a linear movement unit in this embodiment, a screen print chamber 902, an outgoing conveyor 912 and a system controller 900. The incoming conveyor 911 can be configured to receive a substrate 650 from an input device, such as an input conveyor 913 (that is, path "A" in Figure 14), and transfer the substrate 650 to a printing nest 931 coupled at inlet to the actuator assembly 930. The outgoing conveyor 912 can be configured to receive an unprocessed substrate 650 from a printing nest 931 coupled at exit to the actuator assembly 930 and transfer the substrate 650 to a substrate removal device, such as an exit conveyor 914 (that is, path "E" in Figure 14). The input conveyor 913 and the exit conveyor 914 may be automated substrate handling devices that are part of a larger production line.

The incoming conveyor 911 transports the substrates 650 from position "1" in which a substrate 650 is introduced into the screen-printing chamber 902, a position "2" inside the screen-printing chamber 902, and a third position "3" in which the processed substrate 650 is discharged from the screen-printing chamber 902 and conveyed to other operating stations. In the case of a double or multiple print, the substrate 650 is again introduced into the screen-printing chamber 902 in position "2" to carry out a second or further printing step and is then discharged again from the screen-printing chamber 902 passing to position "3". This alternate movement is repeated a number of times coordinated with the number of layers to be printed, until the final product is definitively discharged.

As illustrated in Figure 15, a printing nest 931 generally consists of a conveyor assembly 1039 that has a feed spool 1035, a take-up spool 1036, rollers 1040 and one or more actuators 1048, which are coupled to the feed spool 1035 and/or take-up spool 1036, that are adapted to feed and retain a supporting material 1037 positioned across a platen 1038. The platen 1038 generally has a substrate supporting surface on which the substrate 650 and supporting material 1037 are positioned during the screen printing process performed in the screen print chamber 902. In one embodiment, the supporting material 1037 is a porous material that allows a substrate 650, which is disposed on one side of the supporting material 1037, to be retained on the platen 1038 by a vacuum applied to the opposing side of the supporting material 1037 by a conventional vacuum generating device (*e.g*., vacuum pump, vacuum ejector). In one embodiment, a vacuum is applied to vacuum ports (not shown) formed in the substrate supporting surface of the platen 1038 so that the substrate 650 can be "chucked" to the substrate supporting surface of the platen 1038. In one embodiment, the supporting material 1037 is a transpirable material that consists, for instance, of a transpirable paper of the type used for cigarette rolling paper or another analogous material, such as a plastic or textile material that performs the same function.

In one configuration, the actuators 1048 are coupled to, or are adapted to engage with, the feed spool 1035 and a take-up spool 1036 so that the movement of a substrate 650 positioned on the supporting material 1037 can be accurately controlled within the printing nest 931. In one embodiment, feed spool 1035 and the take-up spool 1036 are each adapted to receive opposing ends of a length of the supporting material 1037. In one embodiment, the actuators 1048 each contain one or more drive wheels 1047 that are coupled to, or in contact with, the surface of the supporting material 1037 positioned on the feed spool 1035 and/or the take-up spool 1036 to control the motion and position of the supporting material 1037 across the platen 1038.

In one embodiment, the system 910 shown in Figures 9-14 comprises an inspection assembly 1000, which is described in more detail in Figures 16-18. The inspection assembly 1000 is adapted to inspect a substrate 650 located on the printing nest 931.

With particular reference to system 910 in Figures 9 and 10, the inspection assembly 1000 is able to inspect a substrate 650 disposed on the printing nest 931 in position "1" and in position "3". The inspection assembly 1000 may comprise one or more cameras 921 positioned to inspect an entering or processed substrate 650, disposed on the printing nest 931 in position "1" and a processed substrate 650 in position "3", following the direction of rotation of the actuator assembly 930.

With particular reference to system 910 in Figures 11 and 12, the inspection assembly 1000 is able to inspect the substrates 650 before and after the processing has been carried out. The inspection assembly 1000 may include one or more cameras 921 which are positioned to inspect a substrate 650 positioned in positions "1" and "3" for loading/unloading.

With particular reference to system 910 in Figures 13 and 14, the inspection assembly 1000 is able to inspect a substrate 650 disposed on the printing nest 931 in position "3". The inspection assembly 1000 may comprise a camera 921 positioned to inspect a processed substrate 650 in position "1" or in position "3", depending on whether the printing nest 931 is moved forward or backward with respect to the path "A" according to the direction of movement of the actuator assembly 930.

In these configurations the inspection assembly 1000 includes at least one camera 921 (*e.g*., CCD camera) and other electronic components capable of inspecting and communicating the inspection results to the system controller 900 used to analyze the orientation and position of the substrate 650 on the printing nest 931. In another embodiment, the inspection assembly 1000 comprises the optical inspection system 1100, discussed above.

In an effort to directly determine the alignment and orientation of the heavily doped regions 641 formed on the substrate surface 651 prior to forming a patterned conductive layer thereon, the system controller 900 may use one or more inspection assemblies 1000 to collect the desired data.

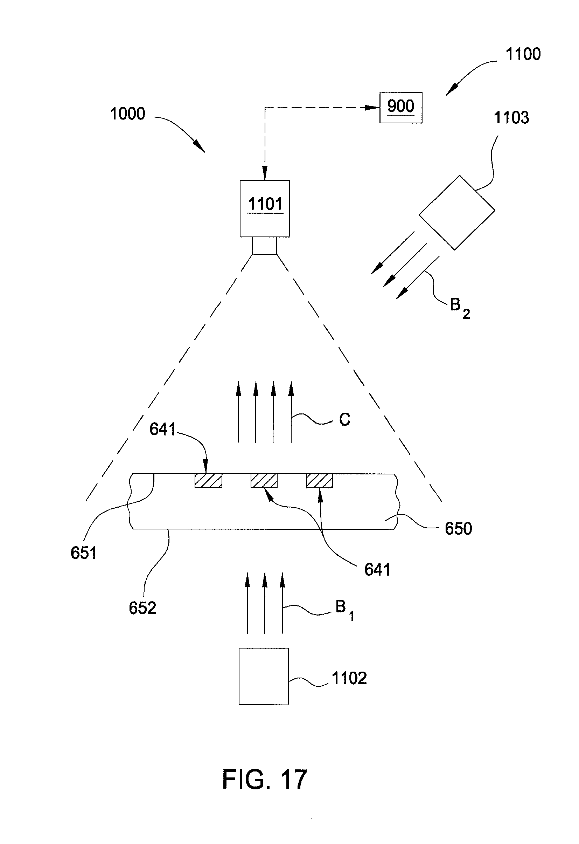

Figure 17 illustrates one embodiment of the optical inspection system 1100 that is incorporated into part of the printing nest 931 and the inspection assembly 1000 as exemplarily shown in Figure 14. In one embodiment, the inspection assembly 1000 comprises a detector device 1101, such as a camera, and the printing nest 931 comprises a conveyor assembly 1039, a supporting material 1037, a platen 1038, and a radiation source 1102. In this configuration, the radiation source 1102 is adapted to emit electromagnetic radiation "B₁" to a surface 652 of a substrate 650 through the supporting material 1037 and platen 1038 on which the substrate 650 is "chucked." The emitted electromagnetic radiation "B₁" then passes through portions of the substrate and follows path "C" to the detector device 1101 that is positioned to receive a portion of the emitted radiation. In general, the supporting material 1037 and platen 1038 are made from materials and have a thickness that will not significantly affect the signal-to-noise ratio of the electromagnetic radiation received and processed by the detector device 1101 and system controller 900. In one embodiment, the platen 1038 is formed from an optically transparent material, such as sapphire, that will not significantly block the UV and IR wavelengths of light. As discussed above, in another embodiment, a radiation source 1103 is configured to deliver electromagnetic radiation "B2" to a surface 651 of a substrate 650 that is positioned on the supporting material 1037 and the platen 1038 so that one or more of the emitted wavelengths will be absorbed or reflected by portions of the substrate 650 and delivered to the detector device 1101 following path "C".

Figures 9 and 11 show one embodiment of the actuator assembly 930 associated with an inspection assembly 1000 that is positioned to inspect a surface 651 of a substrate 650 disposed on a printing nest 931, in position "1" and in position "3".

Figure 13 shows an embodiment of the actuator assembly 930 associated with an inspection assembly 1000 which is positioned to inspect a surface 651 of a substrate 650 disposed on a printing nest 931, in position "1" or in position "3".

Typically, the proper alignment of the substrate 650 in the system 910 is dependent on the alignment relative to a feature of the substrate 650, or to one or more markers, suitably printed. However, a person of skill will appreciate that, with the present invention, it is not necessary to provide different features of the substrate 650 between the first and second printing, nor to print or position markers during the printing of the first patterned printed layer.

In any case, the poor alignment of the subsequent layers screenprinted on the surface 651 of the substrate 650 may influence the capacity of the device formed to function correctly and thus influence the performance of the device. However, minimizing positional errors becomes even more critical in applications where a screen printed layer is to be deposited on top of another formed pattern, such as disposing a conductive layer on the heavily doped region(s) 641.

### Optical inspection system

Embodiments of the invention thus provide to determine the actual alignment and orientation of the patterned heavily doped regions 641, printed in the first printing step 105, corresponding to the verification steps 125A, 125B, 125C as described in Figure 3, and then performing a second and third printing step 110, 115, to form the metal contacts according to a multilayer pattern on the surface of the heavily doped regions 641 (Figures 6-8 and 17) using the information collected by the closed-loop feedback calculation steps that use the stored images of the previous patterned printed layers.

Figures 16-18 illustrate embodiments of an optical inspection system 1100 that can be used as the above-mentioned more general first detection device 452 (Figures 4 and 5) and is, thus, configured to determine the actual alignment and orientation of the pattern of the heavily doped region(s) 641 formed on a surface of a substrate 650 (Figures 6-8 and 17). The optical inspection system 1100 generally contains one or more electromagnetic radiation sources, such as radiation sources 1102 and 1103 that are configured to emit radiation at a desired wavelength and a detector device 1101 that is configured to capture the reflected or un-absorbed radiation so as to acquire relative optical images of the printed patterned layers, so that the alignment and orientation of the heavily doped regions 641 and the wider metal fingers 660 (Figures 6-8) and the narrow metal finger structure 800 (Figure 8) of the multilayer pattern can be optically determined relative to the other non-heavily doped regions of the substrate 650. The optical images acquired by the detector device 1101, from which the orientation and alignment data is derived, are then delivered to a system controller 900 that is configured to operate the closed-loop feedback calculation step 135C, 150B (Figure 3) and consequently to adjust and control the placement alignment of the substrate for the purpose of the second printing step 110 (Figure 3) and the third printing step 115 (Figure 3) of the metal contact structure, such as metal fingers 660 and narrow metal finger structures 800, on the surface of the heavily doped regions 641 by use of patterned metallization technique.

Multilayer patterned metallization techniques may include screen printing processes, ink jet printing processes, lithographic and blanket metal deposition process, or other similar patterned metallization processes. In one embodiment, the metal contacts are disposed on the surface of the substrate 650 using a screen printing process performed in a screen printing system 910, as described herein in conjunction with Figures 9-14.

In configurations where the heavily doped regions 641 are formed within a silicon substrate, it is believed that electromagnetic radiation emitted at wavelengths within the ultraviolet (UV) and infrared (IR) wavelength regions will either be preferentially absorbed, reflected or transmitted by the silicon substrate or heavily doped regions 641. The difference in the transmission, absorption or reflection of the emitted radiation can thus be used to create some discernible contrast that can be resolved by the detector device 1101 and the system controller 900. In one embodiment, it is desirable to emit electromagnetic radiation at wavelengths between about 850 nm and 4 microns (µm). In one embodiment, one or more of the radiation sources 1102 and 1103 are light emitting diodes (LEDs) that are adapted to deliver one or more of the desired wavelengths of light.

In one embodiment, the optical inspection system 1100 has a radiation source 1102 that is configured to deliver electromagnetic radiation "B₁" to a surface 652 of a substrate 650 that is opposite to the side of the substrate on which the detector device 1101 is disposed. In one example shown in Figure 17, the radiation source 1102 is disposed adjacent to the backside (*e.g*., surface 652) of a solar cell substrate 650 and the detector device 1101 is disposed adjacent to the front surface (*e.g*., surface 651) of the substrate 650. In this configuration, it is desirable to use optical radiation greater than the absorption edge of silicon, such as greater than 1060 nm to allow emitted electromagnetic radiation "B1" to pass through the substrate 650 and be delivered to the detector device 1101 following path "C". It is believed that due to the high doping level (*e.g*., >10¹⁸ atoms/cm³) in the heavily doped regions versus the typically lightly doped silicon substrate (*e.g*., <1017 atoms/cm3), typically used in solar cell applications, the absorption or transmissive properties will be significantly different for each of these regions within these wavelengths. In one embodiment, it is desirable to confine the emitted wavelengths in a range between about 1.1 µm and about 1.5 µm. In one example, the heavily doped regions have a resistivity of at least 50 Ohms per square.

In another embodiment of the optical inspection system 1100, a radiation source 1103 is configured to deliver electromagnetic radiation "B2" to a surface 651 of a substrate 650 that is on the same side of the substrate as the detector device 1101. In this manner, one or more of the emitted wavelengths will be absorbed or reflected by portions of the substrate 650, portions of the heavily doped regions 641, as well as portions of the metal fingers 660 (Figures 6-8) and the narrow metal finger structure 800 (Figure 8), if present on the substrate 650. The reflected radiation is emitted to the detector device 1101 following path "C". In this configuration, it is desirable to emit optical radiation at wavelengths between about 850 nm and 4 microns (µm) until a desired contrast between the regions can be detected by the detector device 1101.

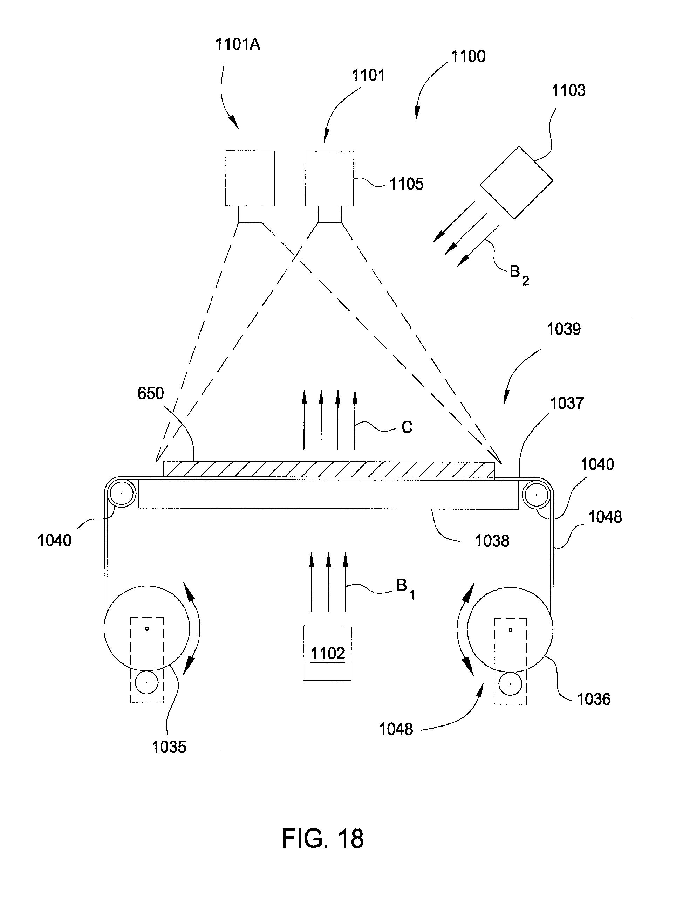

In one embodiment of the optical inspection system 1100, two radiation sources 1102 and 1103 and one or more detector devices 1101 and 1101A (shown in Figure 18) are used to help further detect the pattern of the heavily doped regions 641, the metal fingers 660 (Figures 6-8) and the narrow metal finger structures 800 (Figure 8), on the surface of the substrate 650. In this case, it may be desirable to configure the radiation sources 1102 and 1103 so that they emit radiation at the same or different wavelengths.

The detector device 1101 includes an electromagnetic radiation detector, camera, or other similar device that is configured to measure the intensity of the received electromagnetic radiation at one or more wavelengths. In one embodiment, the detector device 1101 includes a camera 1105 (Figures 16 and 18) that is configured to detect and resolve features on a surface of a substrate within a desired wavelength range emitted by one or more of the radiation sources 1102 or 1103. In one embodiment, the camera 1105 is an InGaAs type camera that has a cooled CCD array to enhance the signal-to-noise ratio of the detected signal. In some configurations, it is desirable to isolate the detector device 1101 from ambient light by enclosing or shielding the areas between the surface 651 of the substrate 650 and the camera 1105.

In one embodiment, the detector device 1101 also includes one or more optical filters (not shown) that are disposed between the camera 1105 and the surface 651 of the substrate 650. In this configuration, the optical filter(s) is/are selected to allow only certain desired wavelengths to pass to the camera 1105 to reduce the amount of unwanted energy being received by the camera 1105 to improve the signal-to-noise ratio of the detected radiation. The optical filter(s) can be a bandpass filter, a narrowband filter, an optical edge filters, a notch filter, or a wideband filter purchased from, for example, Barr Associates, Inc. or Andover Corporation. In another aspect of the invention, an optical filter is added between the radiation sources 1102 or 1103 and the substrate 650 to limit the wavelengths projected onto the substrate and detected by the camera 1105. In this configuration, it may be desirable to select radiation sources 1102 or 1103 that can deliver a broad range of wavelengths and use filters to limit the wavelengths that strike the surface 651 of the substrate 650.

To this purpose, in one embodiment, a camera 1105 is positioned over the surface 651 of the substrate 650 so that a viewing area 675 of the camera 1105 can inspect at least one region of the surface 651. As described above, the information received by the camera 1105 is used to align the screen printing mask, and thus subsequently deposited material, to the heavily doped regions 641 by use of commands sent to the actuators 902A from the system controller 900. During normal process sequencing the heavily doped region 641 position information data is collected for each substrate 650 positioned on each printing nest 931 before it delivered to the screen print chamber 902. The inspection assembly 1000 may also include a plurality of optical inspection systems 1100 that are adapted to view different areas of a substrate 650 positioned on a printing nest 931 to help better resolve the pattern 630 formed on the substrate.

The present invention is set forth and characterized in the independent claims, while the dependent claims describe other characteristics of the invention or variants to the main inventive idea. In accordance with the above purpose, one embodiment of a method according to the present invention is used for the closed-loop feedback control of the printing of a multilayer pattern on a substrate.

The method according to the present invention comprises at least a first printing step on the substrate of a first patterned layer, at least a step of aligning the substrate, at least a second or subsequent printing step on the substrate of a second, or subsequent, patterned layer over the first patterned layer, and a step of verifying the precision of the alignment after the at least one second or subsequent printing step, in which the outcome of the verification is used in the alignment step, in order to improve the precision.

In one embodiment, the verification step comprises a first operation of acquiring a first optical image of the first patterned layer after the first printing step and before the at least one second or subsequent printing step in order to detect the coordinates of the position of the first patterned layer on the substrate. The verification may comprise the step of memorizing at least the first optical image and the coordinates of the position of the first patterned layer on the substrate associated therewith. The verification step may also comprise at least a second or subsequent operation of acquiring a second or subsequent optical image of the second or subsequent patterned layer printed on the first patterned layer after the at least one second or subsequent printing step. The verification step may also comprise a calculation step in closed-loop feedback using the first optical image memorized and the coordinates of the position of the first patterned printed layer on the substrate associated therewith and the second or subsequent optical image acquired directly, in order to control or correct the position of the second or subsequent patterned layer, by intervening in the alignment step.

In another embodiment, an apparatus for the closed-loop feedback control for printing a multilayer pattern on a substrate is provided. The apparatus comprises a first printing station to print a first patterned layer on the substrate, at least alignment means to align the substrate, at least a second printing station to print a second, or subsequent, patterned layer on the substrate, over the first patterned layer, at least control means to verify the precision of the alignment after the printing of the second or subsequent patterned layer and configured to feedback the datum deriving from the verification to at least the alignment means, in order to improve the precision.

One purpose of the present invention is to provide a method for the closed-loop feedback control of the printing of a multilayer pattern on a substrate, which allows the correct reciprocal alignment of the printed layers. The method is useful even if the previous layer is completely covered by subsequent layers.

Furthermore, one purpose of the present invention is to prevent zones in which there is no double printing, so as to increase the performance of the multilayer substrate thus obtainable. Another purpose is to reduce, if not eliminate, the masking effect of the active surface due to the presence of the markers.

The multilayer structures, for example formed by a first layer and a second layer superimposed upon the first, allow to increase the current delivered from the contacts, but make the printing process more complex since one needs to assure that the various layers are correctly aligned with each other, with a precision generally in the range of 10 microns (µm). Typically, if the movement of the substrate on an automated transfer device, and the movement of a printing head are not well controlled the deposited pattern will be improperly formed.

In one embodiment, said control means: are associated to detection devices configured to directly acquire both a first optical image of the first patterned layer before the second or subsequent layer is printed, to detect the coordinates of the position of the first patterned layer on said substrate, and at least a second or subsequent optical image of the second or subsequent patterned layer printed on the first patterned layer, are associated to memorization means in which to memorize at least the first optical image of the first patterned layer and the coordinates of the position of the first patterned layer on the substrate associated therewith, and also are associated to one or more control and command units configured to carry out a verification of the alignment by means of a calculation in closed-loop feedback using the first optical image memorized and the coordinates of the position of the first patterned layer on the substrate associated therewith and the second or subsequent optical image acquired directly, so as to command, on the basis of said calculation in closed-loop feedback, the alignment means of the substrate, in order to correct the position of the second or subsequent patterned layer.

In one embodiment of the present invention, the memorization means are included in said one or more control and command units. In another embodiment of the present invention, the first printing station coincides with the second or subsequent printing station. In another embodiment of the present invention, the first printing station is different from the second or subsequent printing station.

The detection devices can be made and configured according to different variant forms, for example providing a single detection device for all the printing steps and/or the printing stations and/or substrates to be printed, or dedicated detection devices for each printing step and/or printing station and/or substrate to be printed.

In one embodiment, for example, a specific detection device can be provided at inlet or at outlet to/from a determinate printing station and another specific detection device at outlet from said printing station.

In another embodiment, for example, a single specific detection device can be provided at an inlet or at an outlet to/from a determinate printing station, with the provision of suitably moving the substrate so that the single detection device is able to acquire images of both the first print and the second or subsequent print.

The inventors have devised, tested and embodied the present invention to overcome the shortcomings of the state of the art and to obtain these and other purposes and advantages. Embodiments of the invention include a method and plant for the closed-loop feedback control of the printing of a multilayer pattern on a substrate or support. A typical application of the present invention is for processing substrates, for example, made from silicon or alumina, which can be used to form photovoltaic cells or green-tape type circuits.

With the present invention, it is possible to use the closed-loop feedback control even if the subsequent print completely covers the previous print. Moreover, since it is not necessary with the present invention to use different printing nets or masks, it is possible to avoid obtaining zones in which there is no double printing, thus increasing the performance of the multilayer substrate thus obtainable. Furthermore, by reducing or eliminating the use of markers, which may possibly be printed only in the second or subsequent printing operation, the masking effects of the active surface are eliminated.

While the foregoing is directed to embodiments of the present invention, other and further embodiments of the invention may be devised without departing from the basic scope thereof, and the scope thereof is determined by the claims that follow.

## Claims

1. A solar cell formation process, comprising:
positioning a first substrate on a substrate receiving surface of a first printing station;
printing a first patterned layer on a region of the first substrate;
acquiring a first image of the first patterned layer and storing the first image in a buffer;
transferring the first substrate to a substrate receiving surface of a second printing station;
printing a second patterned layer over the region of the first substrate;
acquiring a second image of the second patterned layer; and
performing a closed-loop calculation step using the first image and the second image to determine alignment of the second patterned layer with the first patterned layer.

2. The process of claim 1, further comprising:
positioning a second substrate having the first patterned layer disposed thereon on a substrate receiving surface of the second printing station; and
printing a second patterned layer on the first patterned layer after performing the closed-loop calculation step.

3. The process of claim 2, further comprising:
printing a third patterned layer over the second patterned layer on the second substrate, wherein the third patterned layer is aligned over the second patterned layer using information received from the closed-loop calculation step.

4. The process of claim 3, wherein the second and the third patterned layers comprise a metallic material.

5. The process of claim 3, further comprising:
aligning the substrate before printing the third patterned layer using information received from the closed-loop calculation step.

6. The process of claim 1, wherein the first image comprises an optical image, and the optical image is stored as digital data in a control unit, the digital data comprising the coordinates of the position of the first patterned layer.

7. The process of claim 6, wherein the digital data is transmitted to an alignment device disposed in the second printing station.

8. The process of claim 1, wherein the acquiring the first image further comprises illuminating the first surface with electromagnetic radiation.

9. A solar cell formation process, comprising:
positioning a first substrate on a substrate receiving surface of a first printing station;
printing a first patterned layer on a region of the first substrate;
acquiring a first image of the first patterned layer;
storing the first image in a buffer;
transferring the first substrate to a substrate receiving surface of a second printing station;
printing a second patterned layer over the region of the first substrate, wherein the second patterned layer is aligned over the region of the substrate using information received from the acquired first image;
acquiring a second image of the second patterned layer; and
storing the second image in the buffer.

10. The process of claim 9, further comprising:
performing a closed-loop calculation step using the first image and the second image to determine alignment of the second patterned layer with the first patterned layer.

11. The process of claim 10, further comprising:
positioning a second substrate having the first patterned layer disposed thereon on a substrate receiving surface of the second printing station; and
printing a second patterned layer on the first patterned layer after performing the closed-loop calculation step.

12. The process of claim 11, further comprising:
aligning the second substrate before printing the second patterned layer.

13. The process of claim 11, further comprising:
printing a third patterned layer over the second patterned layer on the second substrate, wherein the third patterned layer is aligned over the second patterned layer using information received from the closed-loop calculation step.

14. The process of claim 11, wherein the first image comprises digital data, and the digital data is transmitted to an alignment device disposed in the first printing station or the second printing station.

15. The process of claim 14, further comprising:
aligning the substrate before printing the second patterned layer.
